Europäisches Patentamt

European Patent Office

Office européen des brevets

(19)

(11) Veröffentlichungsnummer : **0 391 354 B1**

## (12) EUROPÄISCHE PATENTSCHRIFT

(45) Veröffentlichungstag der Patentschrift :
09.11.94 Patentblatt 94/45

(51) Int. Cl.$^5$ : **H04L 1/00,** H03M 13/12

(21) Anmeldenummer : **90106375.0**

(22) Anmeldetag : **03.04.90**

(54) **Verfahren zum Verallgemeinern des Viterbi-Algorithmus und Einrichtungen zur Durchführung des Verfahrens.**

(30) Priorität : **03.04.89 DE 3910739**

(43) Veröffentlichungstag der Anmeldung :
**10.10.90 Patentblatt 90/41**

(45) Bekanntmachung des Hinweises auf die
Patenterteilung :
**09.11.94 Patentblatt 94/45**

(84) Benannte Vertragsstaaten :
**FR GB SE**

(56) Entgegenhaltungen :
**EP-A- 0 133 480**
**WO-A-88/05571**
**GB-A- 2 189 669**
**US-A- 4 015 238**
**US-A- 4 748 626**
**IEE PROCEEDINGS-I, Bd. 136, Nr. 1, Februar 1989,STEVENAGE, HERTS.,GB Seiten 87 - 99; CHEUNG ET AL: 'INFLUENCE OF DESIGN ON-PERFORMANCE OF A SATELLITE MODEM TRANSMITTING CODED PSK SIGNALS'**

(73) Patentinhaber : **Deutsche Forschungsanstalt für Luft- und Raumfahrt e.V.**
**Linder Höhe**
**Postfach 90 60 58**
**D-51126 Köln (DE)**

(72) Erfinder : **Hagenauer, Joachim, Dr. Ing.**
**Roseggerstrasse 41**
**D-8031 Seefeld (DE)**
Erfinder : **Höher, Peter, Dipl.-Ing.**
**Roseggerstrasse 33a**
**D-8031 Seefeld (DE)**

(74) Vertreter : **von Kirschbaum, Albrecht, Dipl.-Ing.**
**Patentanwalt,**
**Postfach 15 20**
**D-82102 Germering (DE)**

EP 0 391 354 B1

## Beschreibung

Die Erfindung betrifft ein Verfahren zum Verallgemeinern des Viterbi-Algorithmus sowie Einrichtungen zur Durchführung des Verfahrens.

Der von G.D. Forney in Proc of the IEEE, Vol. 61, Nr. 3 Seiten 268 bis 278, März 1973 beschriebene Viterbi-Algorithmus ist ein Standardmittel in Nachrichtenempfängern geworden, mit welchem verschiedene Funktionen, wie eine Demodulation, ein Decodieren, eine Entzerrung usw. durchgeführt werden. Bei zunehmend mehr Anwendungsfällen werden zwei Viterbi-Algorithmen in einer verketteten Weise verwendet. Beispiele hierfür sind codierte Modulationssysteme ohne Bandbreiten-Dehnung, wie codierte QAM ("Quadratur-Amplituden-Modulation") oder CPM ("Kontinuierliche Phasen-Modulation"), wobei Viterbi-Empfänger klassische Modulationsverfahren ersetzen. Bei einem zusätzlichen äußeren Codiersystem könnten Faltungscodes mit Viterbi-Decodierung benutzt werden, um eine Vorwärts-Fehlerkorrektur-(FEC-)Decodierung durchzuführen.

Eine derartige Lösung weist jedoch zwei Nachteile auf: Zum einen erzeugt der innere Viterbi-Algorithmus bei einer Demodulation Fehlerbündel, gegenüber welchen der äußere Viterbi-Algorithmus sehr empfindlich ist, und zum anderen erzeugt der innere Viterbi-Algorithmus harte d.h. binäre Entscheidungen (Hard-Decisions), so daß beim äußeren Viterbi-Algorithmus dessen Leistungsfähigkeit, sogenannte Soft-Decisions, d.h. analoge Entscheidungen zu liefern, nicht ausgenutzt werden kann. Der erste Nachteil kann mit Hilfe einer Spreizung (Interleaving) zwischen dem inneren und äußeren Viterbi-Algorithmus ausgeglichen werden. Im zweiten Fall wären Soft-Decisions, d.h. eine Zuverlässigkeits-Information zusammen mit den Entscheidungen des inneren Viterbi-Algorithmus erwünscht. Hierdürch würde die Wirksamkeit des äußeren Viterbi-Algorithmus beträchtlich verbessert.

Ähnliche Schwierigkeiten ergeben sich dann, wenn Faltungscodes für das Vorwärts-Fehlerkorrektur-(FEC-)Decodieren auf Kanälen benutzt werden, welche eine Entzerrung erfordern. Dies ist beispielsweise bei dem zukünftigen gesamteuropäischen Mobilfunksystem (GSM) der Fall. Hierbei erzeugt ein Viterbi-Entzerrer nur harte Entscheidungen, welche zu einer reduzierten Leistung bei dem äußeren Viterbi-Algorithmus führen, bei welchem eine FEC-Decodierung durchführt wird.

Eine weitere Möglichkeit besteht darin, einen Viterbi-Algorithmus zum Decodieren eines geblockten bzw. terminierten Faltungscodes zu benutzen. Dies ist ein Faltungscode mit Gedächtnis, welcher durch ν bekannte Symbole begrenzt ist. Häufig erfordert auch ein Quellendecodierer eine Zuverlässigkeitsinformation über das richtige Codieren des gesamten Rahmens oder von Teilen, welche zur Überlagerung oder zur Interpolation der Quellensignale benutzt werden können.

Bisher wurde dann, wenn ein innerer Viterbi-Algorithmus benutzt wird, als richtige Wahl für den äußeren Code wegen dessen Bündel-Korrigierbarkeit ein Reed-Solomon-(RS-)Code angesehen, da durch diesen RS-Code die Restfehler des Viterbi-Algorithmus vermindert werden. Jedoch kann die volle Leistung eines RS-Decoders nur dann realisiert werden, wenn eine Fehler- und Lösch-Decodierung angewendet wird. Ein gewünschtes ML-("Maximum-Likelihood"-)Decodieren von RS-Codes ist derzeit noch nicht verfügbar. Sowohl ein Lösch-als auch ein ML-Decodieren würden nämlich "Soft"-Decisions des ersten Viterbi-Algorithmus erfordern, die dann mit einem bestimmten Schwellenwert zu Auslöschungen werden. Mit Hilfe von Soft-Decisions würden sich sogar einfache Blockcodes, wie Parity-Check-Codes, viel besser decodieren lassen.

Der Viterbi-Algorithmus wurde 1967 als ein Verfahren zum Decodieren von Faltungscodes vorgestellt (siehe A.J. Viterbi, IEEE Trans. Inform. Theory, Vol. IT-13 Stn. 260 - 269, April 1967), wobei kurz darauf gezeigt werden konnte, daß der Algorithmus im ML-("Maximum-Likelihood"-)Sinne optimal ist. (Siehe beispielsweise I.K. Omura, in IEEE Trans. Inform. Theory, Vol. IT-15, Stn. 177 - 179, Jan. 1969).

Versuche, die Bitfehler-Wahrscheinlichkeit auf Kanälen mit Nachbarsymbol-Interferenzen zu minimieren, führten zu einer Empfängerstruktur, welche weniger attraktiv als der Viterbi-Algorithmus ist. Dieser Algorithmus wurde daher noch generalisiert (siehe beispielsweise L.B. Bahl u.a. , IEEE Trans. Inform. Theory Vol. IT-20, Stn. 284 - 287, März 1974). Es wurde gezeigt, daß der Algorithmus im Sinne einer MAP-Entscheidung optimal ist und für jedes Bit die entsprechende A-Posteriori-Wahrscheinlichkeit (APP) liefert. Jedoch ist aufgrund der höheren Komplexibilität die Anzahl der Anwendungsmöglichkeiten begrenzt.

Es wurden auch noch zahlreiche weitere Versuche unternommen, eine Zuverlässigkeitsinformation abzuleiten. Der Anmelderin ist jedoch kein Vorschlag bekannt, bei welchem die A-Posteriori-Wahrscheinlichkeiten (APP) des MAP-Detektors oder eine Soft-Decision von einem erweiterten Viterbi-Algorithmus aus benutzt wird, um eine optimale äußere Soft-Decision-Decodierung durchzuführen.

Obwohl von einem Viterbi-Empfänger Soft-Decisions akzeptiert werden, liefert er nur Hard-Decisions. Die nächste Empfängerstufe würde jedoch in vielen Fällen besser arbeiten, wenn Soft-Decisions, d.h. Analogwerte, für jedes Symbol abgeleitet würden. Es gibt jedoch keinen direkten Weg, um im bekannten Viterbi-Algorithmus Soft-Decisions für jedes einzelne Symbol zu extrahieren.

Aufgabe der Erfindung ist es daher, ein Verfahren und eine Einrichtung zum Verallgemeinern eines Viterbi-

2

Algorithmus so auszubilden, daß der Viterbi-Algorithmus analoge Entscheidungen, d.h. Soft-Decisions liefert. Gemäß der Erfindung ist dies bei einem Verfahren zum Verallgemeinern des Viterbi-Algorithmus nach dem Oberbegriff des Anspruchs 1 durch die Merkmale im kennzeichnenden Teil des Anspruchs 1 verwirklicht. Eine Modifizierung des Verfahrens nach Anspruch 1 ist durch die Merkmale im kennzeichnenden Teil des Anspruchs 2 realisiert. Eine vorteilhafte Weiterbildung dieser Verfahren ist im Anspruch 3 angegeben. Eine Einrichtung zur Durchführung der erfindungsgemäßen Verfahren ist im Anspruch 4 angegeben, wobei in den nachfolgenden Unteransprüchen vorteilhafte Weiterbildungen und Modifizierungen der Einrichtung nach Anspruch 4 angeführt sind.

Gemäß der Erfindung wird bei dem Verfahren zur Verallgemeinerung des herkömmlichen Viterbi-Algorithmus, bei welchem in einer Metrik-Inkrement-Einheit (TMU) die Kosten gebildet werden, und in einer nachgeschalteten Addier-Vergleich- und Auswähl-(ACS-)Einheit ein Addieren, ein Vergleichen sowie ein Auswählen vorgenommen werden, für jeden einzelnen Zustand Differenzkosten von zwei eintreffenden Pfaden berechnet, wobei die Zuverlässigkeitsinformation am Anfang jedes Pfades auf den höchsten Wert festgesetzt wird. Anschließend wird der Zuverlässigkeitswert des Pfades mit den kleinsten Kosten an den Stellen aufgefrischt, an welchen die Informationsstellen von dem konkurrierenden Pfad abweichen; hierbei wird das Auffrischen gemäß einer Tabelle vorgenommen, indem der vorherige Wert der Zuverlässigkeitsinformation und die Differenzkosten als neue Eingangsgröße in der Tabelle angelegt werden. Dieser neue Wert wird dann aus der Tabelle entnommen und zusammen mit harten Entscheidungen als sogenanntes Pfadgedächtnis abgespeichert; hierbei kann das Abspeichern in Form von Fest- oder Gleitpunkt-Werten erfolgen. Schließlich wird dann eine Analogwert-Entscheidung aus den Stellen herausgelesen, die sich nach einer gewissen Entscheidungsverzögerung für den Pfad mit den kleinsten Kosten ergibt. Die harten Entscheidungen des bekannten Viterbi-Algorithmus sind die Vorzeichen der Analogwert-Entscheidungen.

Bei dem Verfahren zum Modifizieren des erfindungsgemäßen Verfahrens zum Verallgemeinern des Viterbi-Algorithmus wird zum Auffrischen einer Zuverlässigkeitsinformation das Minimum aus der alten Zuverlässigkeitsinformation und - durch Einführen eines Faktors $\alpha$ - normierten Pfad-Differenzkosten gebildet und dieser neue Wert wird dann als Pfadgedächtnis abgespeichert.

Gemäß einer bevorzugten Weiterbildung der Verfahren zum Verallgemeinern bzw. Modifizieren des Viterbi-Algorithmus ist zum Pfadauffrischen eine Pfad-Auffrischeinheit vorgesehen, durch welche in einem gewissen Bereich ($k - \nu$ bis $k - \delta_p$ mit $\nu \leq \delta_P \leq \delta_m$) die Informationsbits der beiden konkurrierenden Pfade auf Gleichheit überprüft werden und bei Feststellen einer Ungleichheit der Auffrischvorgang aktiviert; hierbei sind mit k ein Zeitindex, mit $\nu$ ein Codegedächtnis und mit $\delta$ eine Verzögerung bzw. Eindringtiefe bezeichnet.

Bei einer bevorzugten Einrichtung zur Durchführung der Verfahren sind neben den bekannten zur Durchführung des Viterbi-Algorithmus erforderlichen Einheiten, nämlich eine Metrik-Inkrement-Einheit (TMU) und einer Addier-Vergleich-Auswähl-Einheit zusätzlich noch ein Pfad-RAM sowie eine Pfad-Auffrischeinheit (PAU) vorgesehen, wobei zum Pfadauffrischen in einem ganz bestimmten Bereich, nämlich in dem Bereich $k - \nu$ bis $k - \delta_m$ die Informationsbits der beiden konkurrierenden Pfade auf Gleichheit überprüft werden und bei einer Ungleichheit der Auffrischvorgang in dem Pfad-RAM aktiviert wird.

Gemäß einer vorteilhaften Weiterbildung der erfindungsgemäßen Einrichtung ist eine Einrichtung zum Normieren des Auffrischens der Zuverlässigkeitsinformation vorgesehen, wobei ein Faktor ($\alpha$) eingeführt wird, wobei dann hierdurch einer Festkomma-Darstellung genügt und gleichzeitig ein Überlauf vermieden ist. Wenn Zeit gewonnen werden soll oder muß, ist für jeden von S Zuständen jeweils eine gesonderte Pfad-Auffrischeinheit (PAU) vorgesehen, wobei dann aufgrund dieser Parallelanordnung im Hinblick auf das Vorsehen nur einer einzigen Pfad-Auffrischeinheit (PAU) ein Zeitgewinn in der Größe des Faktors S erzielt wird.

Ferner kann gemäß einer weiteren vorteilhaften Ausbildung für jedes Zeitintervall ($k - \nu$ bis $k - \delta_p$) jeweils eine gesonderte Pfad-Auffrischeinheit (PAU) vorgesehen sein, wobei dann durch diese Parallelanordnung Zeitgewinne in der Größenordnung eines Faktors, nämlich von $\nu - \delta_p$, erzielbar sind, wobei $\nu$ wieder ein Codegedächtnis und $\delta_p$ eine definierte Verzögerung bzw. Eindringtiefe sind.

Durch die vorliegende Erfindung wird somit ein herkömmlicher Viterbi-Empfänger durch eine sogenannte Soft-Deciding-Einrichtung, d.h. eine Einrichtung erweitert, welche analoge Entscheidungen, d.h. Soft-Decisions liefert, die immer besser als harte, d.h. binäre Entscheidungen, nämlich Hard-Decisions sind. Wieviel hierbei jeweils gewonnen werden kann, hängt jedoch von der Art und Weise ab, wie die nächste Empfängerstufe arbeitet. Hierbei ist im Minimum ein Gewinn von 2 dB erreichbar, während der maximale Gewinn bei mehr als 10 dB liegen kann. In einem klassischen Viterbi-Empfänger kann ein solcher Gewinn auf keinen Fall realisiert werden.

Der Viterbi-Algorithmus (VA) mit einer Analogwert-Entscheidung (SD) ist in all den Bereichen anwendbar, in denen auch der herkömmliche Viterbi-Algorithmus einsetzbar ist, nämlich als Decodierer, als Entzerrer oder als Demodulator für codierte Modulation. In all diesen Fällen muß nur die Metrik-Inkrement-Einheit, d.h. die sogenannte TMU-Einheit in bekannter Weise ausgetauscht werden. Dasselbe gilt auch bei Anwendungsfällen für punktierte Codes oder bei der Verwendung als Demodulator mit reduzierter Zustandsanzahl.

Gemäß der Erfindung könnte daher in einer Empfängerkette ein MAP-(Maximum-A-Posteriori-) oder ein Viterbi-Detektor verwendet werden. Dies könnte ein Viterbi-Entzerrer, ein Viterbi-Demodulator (beispielsweise für Modulationsverfahren konstanter Einhüllender (CPM) oder für eine Trellis-codierte Modulation (TCM)), oder ein Viterbi-Decoder für einen inneren Faltungscode sein. Auf diese Einrichtung folgt dann ein zweiter Detektor, welcher, nach dem Entzerrer ein Demodulator oder ein Decoder, nach dem Demodulator ein Decoder, nach dem inneren Decoder ein äußerer Decoder oder ein Quellendecoder sein könnte. Die Leistung der zweiten Einrichtung wird hierbei dadurch verbessert, daß außer binären Entscheidungen d.h. Hard-Decisions von der ersten Stufe eine Zuverlässigkeits-Information oder Analogwert-Entscheidungen, d.h. Soft-Decisions, verfügbar sind.

Ferner können durch die Erfindung alle eingangs erwähnten Anwendungsmöglichkeiten sowie weitere Anwendungen, wie adaptive Viterbi-Schemen; FEC ("Forward Error Correction") / ARQ ("Automatic Repeat REQuest")-Schemen eine Viterbi-Synchronisation mit Hilfe des erfindungsgemäßen Viterbi-Algorithmus (VA) mit Analogwert-Entscheidungen (SD) bzw. mit Hilfe eines Soft-Deciding-Viterbi-Algorithmus (SDVA) verbessert werden. Dies ist ein Viterbi-Algorithmus, welcher Soft (oder Hard-) Decisions benutzt, um Metriken zu berechnen, jedoch auch soft d.h. analog, und somit nicht in einer harten d.h. binären Form entscheidet. Ein besonders vorteilhafter Weg besteht darin, zusammen mit den Entscheidungen eine Zuverlässigkeitsinformation, d.h. die Wahrscheinlichkeit einer richtigen Entscheidung oder eine logarithmische Wahrscheinlichkeitsfunktion zu liefern.

Der optimale Weg besteht darin, A-Posteriori-Wahrscheinlichkeiten (APP) für die Entscheidung zu berechnen und einen Algorithmus zu bilden, um m̲aximale A̲-P̲osteriori-(MAP-)Entscheidungen zu treffen. Der erfindungsgemäße SDV-Algorithmus unterscheidet sich daher vollständig von dem Viterbi-Algorithmus, obwohl dieser lediglich mit einem kleinen Zusatz in Form einer Analogwert-Entscheidungen liefernden Einheit, einer sogenannten Soft-Deciding-Einheit, versehen zu werden braucht.

Nachfolgend wird die Erfindung anhand von bevorzugten Ausführungsformen im einzelnen erläutert. Es zeigen:

Fig.1    ein Blockdiagramm eines Detektors für einen Viterbi-Algorithmus mit Analogwert-Entscheidungen und mit Zuverlässigkeitsinformation gemäß der Erfindung;

Fig.2    ein Beispiel eines Viterbi-Algorithmus mit Analogwert-Entscheidungen (SDVA);

Fig.3    ein Blockdiagramm eines Viterbi-Algorithmus mit Analogwert-Entscheidungen (SDVA) mit einer sogenannten Pipelining-Wirkung;

Fig.4    ein Blockdiagramm eines Pfad-RAM und eines Metrik-RAM;

Fig.5    schematisch einen Auffrischvorgang bzw. eine Aktualisierung einer Analogwertentscheidung (SD);

Fig.6    eine schematische Darstellung einer Pfad-Auffrischeinheit (PAU) gemäß der Erfindung, und

Fig.7    über der Zeit aufgetragene Ausgangswerte eines Viterbi-Algorithmus mit Analogwert-Entscheidungen (SDVA) gemäß der Erfindung.

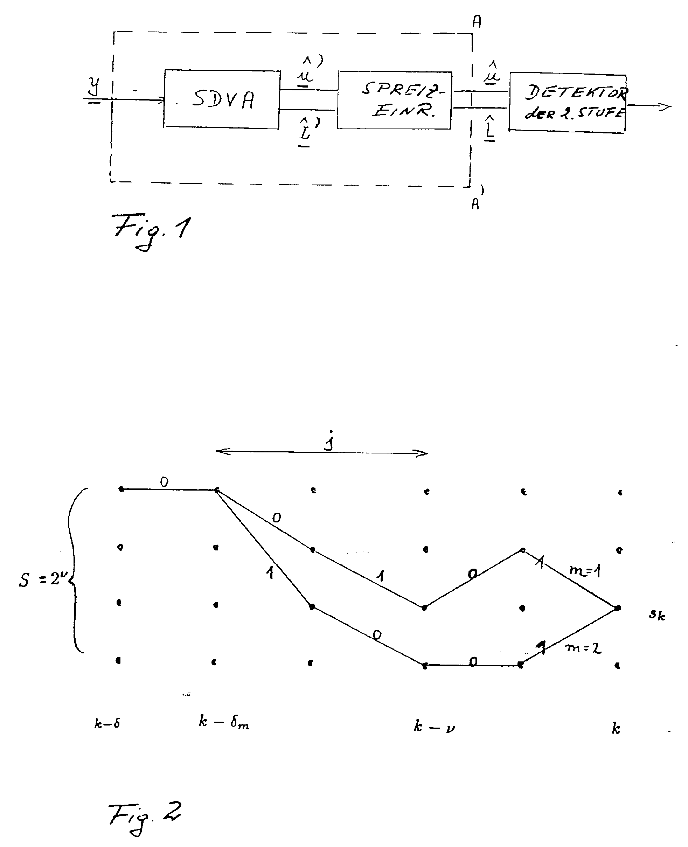

In Fig.1 liefert ein Viterbi-Detektor der ersten Stufe, mittels welchem ein Viterbi-Algorithmus mit Analogwert-Entscheidungen (SDVA) durchgeführt wird, Schätzungen $\hat{u}'$ der Symbolfolge $u'$, indem die empfangene Symbolfolge $y$ in einem MAP-oder Viterbi-Detektor verarbeitet wird. Hierbei soll dann der Detektor für jedes Symbol eine Zuverlässigkeitsinformation liefern, d.h. einen Schätzwert für die Wahrscheinlichkeit, daß dieses Symbol ungenau festgestellt worden ist:

$$P'_k = \text{Prob}\{\hat{u}'_k \neq u'_k \,|\, y\}. \quad (1)$$

Dieser Schätzwert $\hat{u}'$ ist nicht immer richtig. Daher wird eine bedingte Wahrscheinlichkeitsdichte-Funktion $p(\hat{p}'_k \,|\, p'_k)$ vorgesehen, welche den Schätzungsfehler zum Schätzen von $\hat{p}'_k$ beschreibt, welcher durch $p'_k$ gegeben ist. Da der Viterbi-Algorithmus der ersten Stufe korrelierte Fehler in $\hat{u}'_k$ und $\hat{p}'_k$ erzeugt, welche die Leistung der nächsten Stufe verschlechtern können, wird eine hinreichende Spreizung durchgeführt, um eine statistische Unabhängigkeit zu erreichen. (Hierbei sind die Strichindizes weggelassen). Natürlich erfordert dies eine entsprechende, sendeseitige Spreizungseinrichtung.

Bei der gestrichelten Linie A-A' in Fig. 1 liefert der Detektor der ersten Stufe Symbole $\hat{u}_k$ mit statistisch unabhängigen Fehlerwahrscheinlichkeiten $p_k$. Ein derartiger Kanal wird als ein diskreter gedächtnisloser Verbundkanal bezeichnet, welcher einen Schätzwert $\hat{p}_k$ für diese Fehlerwahrscheinlichkeiten $p_k$ liefert. Wenn die Fehlerwahrscheinlichkeitsdichte $p(p_k)$ und die Schätzungsdichte $p(\hat{p}_k \,|\, p_k)$ gegeben sind, kann die Kanalkapzität eines solchen Verbundkanals berechnet werden. Für Binärwerte $u_k$ kann ein derartiger Kanal als ein binärer, symmetrischer Kanal (BSC) mit einer Fehlerwahrscheinlichkeit $p_k$ betrachtet werden, welcher sich von Bit zu Bit mit einem statistisch unabhängigen Wert $p_k$ entsprechend der Dichtefunktion $p(p_k)$ ändert. Diese Fehlerwahrscheinlichkeit kann mit einer Wahrscheinlichkeit $p(\hat{p}_k \,|\, p_k)$ bewertet werden.

Für einen Detektor der zweiten Stufe ist der Kanal ein diskreter (binärer) gedächtnnisloser Verbundkanal

mit Ausgangs-Paarwerten $(\hat{u}_k, \hat{p}_k)$. Wenn der Detektor der zweiten Stufe eine ML-(Maximum-Likelihood") Detektion durchführt, ist die optimale ML-Metrik

$$\sum_k x_k^{(m)} \cdot \hat{u}_k \log \frac{1 - \hat{p}_k}{\hat{p}_k}, \qquad (2)$$

wobei $x_k^{(m)} = \pm 1$ das k-te Symbol der m-ten Informationsfolge ist. Der Wert $\hat{u}_k$ ist die harte Entscheidung ($\pm 1$) des ersten Viterbi-Detektors. Da diese harte Entscheidung mit $\log 1\text{-}\hat{p}_k/\hat{p}_k$ zu bewerten ist, kann $\hat{u}_k \log(1\text{-}\hat{p}_k)/\hat{p}_k$ als eine Soft-Decision-Variable betrachtet werden. Folglich wird der erste Viterbi-Algorithmus als ein Soft-Deciding-Viterbi-(SDV-)Algorithmus bezeichnet, da er Soft-Decisions

$$\hat{u}_k \log \frac{1 - \hat{p}k}{\hat{p}k} \quad (3)$$

liefert, welche von der nächsten ML-Detektorstufe zu verarbeiten sind. Der Detektor der nächsten Stufe kann wieder ein Viterbi-Algorithmus sein, welcher Soft-Decisions akzeptiert und schließlich harte Entscheidungen liefert. Zweckmäßigerweise kann er wieder ein Soft-Deciding-Viterbi-(SDV-)Algorithmus sein, welcher zusammen mit den Entscheidungen eine Zuverlässigkeitsinformation liefert, welche in einem Decoder der nächsten Stufe oder dem Quellendecoder brauchbar sein könnte. Ebenso könnten die Soft-Decision nach (3) in drei Werte (-1,0,+1) quantisiert werden, die folglich Fehler und Löschungen anzeigen, welche verwendbar sind, wenn der Detektor der zweiten Stufe ein RS- oder anderer Blockcode-Decoder ist.

Der Viterbi-Algorithmus (VA) ist dann zu modifizieren, damit er ein Soft-Deciding-Viterbi-(SDV-)Algorithmus wird, welcher Soft-Decisions (3) mit $\hat{p}_k$ liefert, welcher, soweit wie möglich $p_k$, angenähert ist. Nachstehend werden nun zwei Lösungen untersucht:

Bei der ersten Lösung erzeugt eine Einrichtung Entscheidungen mit einem optimalen Wert von $\hat{p}_k = p_k$ bzw. einen optimalen Wert für $\log(1\text{-}\hat{p}_k)/\hat{p}_k = \log(\text{-}1p_k)/p_k$. Dies ist der bekannte "Maximum" A-Posteriori-(MAP-)Algorithmus, welcher einen Schätzwert für $p_k$ einschließt. Dieser Algorithmus, der hier als Soft-Deciding-MAP-(SDMAP-)Algorithmus bezeichnet wird, unterscheidet sich von dem Viterbi-Algorithmus und ist komplexer. Die erste Lösung ist nicht Gegenstand des vorliegenden Verfahrens, sondern dient nur der Referenz.

Die zweite Lösung ist der SDV-Algorithmus, für welchen gefordert wird, daß er dieselben harten Entscheidungen wie der Viterbi-Algorithmus liefert, welche nur ML für die Folge und nicht MAP für die Symbole sind. Daher wird der ursprüngliche Viterbi-Algorithmus genommen und durch eine Fehlerwahrscheinlichkeit-Bewertungseinrichtung vergrößert, welche schließlich den Wert $\hat{u}_k \log(1\text{-}\hat{p}_k)/\hat{p}_k$ für jedes Bit $u_k$ als den Soft-Decision-Wert liefert. Hierbei soll die zusätzliche Komplexibilität so klein wie möglich gehalten werden. Ferner sollen Soft Decisions zum selben Zeitpunkt k erhalten werden, an welchem die Entscheidung von $u_k$ verfügbar ist, um weitere Verzögerungen zu vermeiden.

Hinsichtlich des Empfängers erfolgt der Einfachheit halber eine Beschränkung auf Netzdiagramme mit zwei Zweigen, die an jedem Knotenpunkt enden. Bei Netz- oder Trellisdiagrammen mit mehr als zwei Pfaden pro Zustand muß in optimaler Weise der überlebene Pfad ("Surviver Path") nacheinander für jeden anderen Pfad verglichen werden. Damit ist die Suche auf den binären Fall reduziert, und das Verfahren läuft so, wie es beschrieben ist, ab. Eine aufwandsgünstigere Methode besteht darin, den überlebenden Pfad nur mit den P nächstbesten Pfaden zu vergleichen, im Extremfall nur mit dem zweitbesten Pfad, wobei dann P = 1 ist.

Bei einem konventionellen Faltungscode der Rate 1/N werden zu jedem eintreffenden Informationsbit genau N Kanalbits übertragen; werden nunmehr nicht alle Kanalbits übertragen, sondern geeignete Kanalbits gelöscht bzw. "gelocht", so wird ein Code der Rate K/N erhalten. Die Coderate kann also erhöht werden. Der Vorteil der gelochten Codes besteht darin, daß das Trellisdiagramm prinzipiell gleich bleibt, insbesondere bleibt die Anzahl der Pfade unverändert. Dadurch wird der Codieraufwand nicht verändert. Dies schließt gelochte Codes der Rate K/N ein, welche von einem Code der Rate 1/N ausgehen, da sie das Netzdiagramm des Codes der Rate 1/N benutzen.

Die Anzahl von Zuständen S des Decoders ist $S = 2^\nu$, wobei $\nu$ das Codegedächtnis ist; es sind jedoch auch Decoder mit reduzierter Zustandsanzahl möglich.

Der klassische Viterbi-Algorithmus trifft eine endgültige Entscheidung mit einer Verzögerung $\delta$, wobei $\delta$ groß genug ist, so daß alle $2^\nu$-Überlebenspfade mit einer ausreichend hohen Wahrscheinlichkeit zusammengelaufen sind. Wie in Fig. 2 dargestellt, hat der Viterbi-Algorithmus je einen Überlebenspfad für den Zustand $s_k$ zum Zeitpunkt k, wobei $1 \leqq s_k \leqq S = 2^\nu$ ist. Dies geschieht durch Auswählen des Pfads mit der maximalen Wahrscheinlichkeits-Metrik, welche für den Gaußschen Kanal der Logarithmus der Gaußschen Wahrscheinlichkeitsdichte ist.

$$M_m = -\frac{E_s}{N_0} \sum_{j=k-\delta}^{k} \sum_{n=1}^{N} (y_{jn} - x_{jn}^{(m)})^2, \qquad m = 1, 2, \qquad (4)$$

wobei $x_{jn}^{(m)}$ das n-te Bit von N Bits in dem Zweig für den m-ten Pfad zum Zeitpunkt j ist, $y_{jn}$ der empfangene Wert an derselben Position ist, und $E_s/N_0$ das Signal-Rauschleistungsverhältnis (SNR) ist. Mit Hilfe dieser Formel ergibt sich dann:

$$Prob\{path\ 1\} \sim e^{M_1}$$
$$Prob\{path\ 2\} \sim e^{M_2}, \quad (5)$$

wenn der Pfad mit der höheren Metrik mit m = 1 bezeichnet wird. Dies bedeutet dann $M_1 \geqq M_2$, was wiederum beinhaltet, daß der Viterbi-Algorithmus den Pfad 1 auswählt.Die Wahrscheinlichkeit, daß der falsche Überlebenspfad gewählt wird, ist dann:

$$p_{sk} = \frac{e^{M_2}}{e^{M_1} + e^{M_2}} = \frac{1}{1 + e^{M_1 - M_2}} = \frac{1}{1 + e^{\Delta}}, \qquad \Delta = M_1 - M_2 \geqq 0. \quad (6)$$

Der Wert von $p_{sk}$ ist 0,5, wenn $M_1 \approx M_2$ ist, und nähert sich 0, wenn $M_1 \gg M_2$ ist. Mit dieser Wahrscheinlichkeit $p_{sk}$ hat der Viterbi-Algorithmus Fehler an all den e-Positionen gemacht, wo die Informationsbits des Pfads 2 sich von dem Pfad 1 unterscheiden. Hierbei sind mit e Positionen die Anzahl der Positionen bezeichnet, an denen die Informationsbits der beiden untersuchten Pfade voneinander abweichen. Beispielsweise weichen in Fig.2 die Informationsbit im Intervall von k-4 nach k-3 und im Intervall von k-3 nach k-2 ab. In allen anderen Zeitabschnitten sind die Bits paarweise gleich. Also ist in diesem Beispiel e = 2.

$$u_j^{(1)} \neq u_j^{(2)}, \qquad j = j_1,...,j_e. \quad (7)$$

Positionen, an welchen $u_j^{(1)} = u_j^{(2)}$ ist, werden nicht beeinflußt. Der Wert $\delta_m$ soll die Länge dieser beiden Pfade sein, bis sie zusammentreffen. Es ergeben sich dann e verschiedene Informationswerte und ( $\delta_m$ - e) nicht-verschiedene Werte. Wenn nunmehr die Wahrscheinlichkeiten $p_j$ von vorherigen fehlerhaften Entscheidungen beim Pfad 1 gespeichert worden sind, dann werden diese Wahrscheinlichkeiten für die e differierenden Entscheidungen auf diesem Weg entsprechend

$$p_j := p_j(1 - P_{sk}) + (1 - p_j)p_{sk}, \qquad j = j_1,...,j_e, \qquad 0 \leqq p_j \leqq 0.5. \quad (8)$$

aktualisiert. Um dies durchzuführen, sind die Informationsbits der beiden Pfade miteinander zu vergleichen, um die Stellen festzulegen, wo sie sich unterscheiden. Hierbei ist jedoch zu beachten, daß die ersten $\nu$ Bits gleich sind, da beide Wege in demselben Bit-Zustand enden. Für alle Zustände kann ein Zeiger $\delta_p$ gespeichert werden, um die maximale Länge von nicht ineinander übergegangenen Wegen anzuzeigen und um nur von j = k- $\nu$ bis j = k - $\delta_p$ zu suchen. Ebenso könnte die Rekursion unmittelbar entsprechend dem Wahrscheinlichkeitsverhältnis durchgeführt werden:

$$L_k = \log \frac{1 - p_k}{p_k} \qquad 0 \leqq L_k < \infty. \quad (9)$$

Mit Hilfe von Gl.'en (6), (8) und (9) wird nach einer entsprechenden Umformung erhalten:

$$L_j := f(L_j, \Delta)$$
$$f(L_j, \Delta) = \frac{1}{\alpha} \log \frac{1 + e^{(\alpha L_j + \Delta)}}{e^{\Delta} + e^{\alpha L_j}}, \qquad \Delta = M_1 - M_2 \geqq 0, \qquad j = j_1,...,j_e. \quad (10)$$

Die Funktion $f(L_j\Delta)$ sollte mit $L_j$ und $\Delta$ als Eingangsveränderlichen tabelliert werden und muß nicht bei jedem Schritt berechnet werden. Der Faktor $\alpha$ verhindert ein Überlaufen bei großem Signal-Rauschleistungs-Verhältnis. Die richtige Wahl des Faktors $\alpha$ ist:

$$\alpha = 4d_{free}\frac{E_s}{N_0}, \quad (11)$$

wobei $d_{free}$ der freie Abstand des Codes ist.

Die Funktion kann auch angenähert werden durch

$$f(L_j, \Delta) = \min(L_j, \Delta/\alpha) \quad (11a)$$

Der Soft-Deciding-Viterbi-(SDV-)Algorithmus kann nunmehr gebildet werden:
Speicherung:

k      (Zeitindex, Modulo $\delta$ + 1)

$\hat{u}(s_k) = \{\hat{u}_{k-\delta}(s_k),...,\hat{u}_k(s_k)\}$,      $1 \leqq s_k \leqq S$ (Hard-Decision-Werte, $\hat{u} \in \{\pm 1\}$)

     (Zuverlässigkeitswerte, (*)

$\hat{L}(s_k) = \{\hat{L}_{k-\delta}(s_k),...,\hat{L}_k(s_k)\}$,      $1 \leqq s_k \leqq S$ Soft Decisions, $0 \leqq \hat{L} \leqq \infty$)

$\Gamma(s_k)$,      $1 \leqq s_k \leqq S$ (akkumulierte metrische Werte = Überlebenskosten)

Initialisierung:

$\hat{u}(s_k) = 0$,      $1 \leqq s_k \leqq S$

$\hat{L}(s_k) = +\infty,$ $\qquad\qquad$ $1 \leq s_k \leq S$ (*)

$\Gamma(s_0) = 0,$ $\qquad \Gamma(i) = +\infty,$ $\qquad i \neq s_0.$

Rekursion:

a) klassischer Viterbi-Schritt:

Für jeden Zustand $s_k$ ist für beide Übergänge $(s_{k-1}, s_k)$ zu berechnen:

$$\Gamma(s_{k-1}, s_k) = \Gamma(s_{k-1}) + \frac{E_s}{N_0} \Sigma_{n=1}^N (y_{kn} - x_{kn}^{(m)})^2$$

Zu finden ist dann:

$$\Gamma(s_k) = \min \Gamma(s_{k-1}, s_k).$$

Zu speichern ist: $T(s_k)$ und der entsprechende Überlebenswert $\hat{u}_k(s_k)$

b) Aktualisierter Soft-Deciding-Wert: $\qquad\qquad\qquad\qquad$ (*)

Für jeden Zustand $s_k$ ist zu berechnen:

$$\Delta = \max \Gamma(s_{k-1}, s_k) - \min \Gamma(s_{k-1}, s_k).$$

Zu initialisieren ist:

$$\hat{L}_k(s_k) = +\infty.$$

Für $j = k - \nu$ bis $j = k - \delta_m$ sind die zwei Wege zu vergleichen, welche bei $s_k$ ineinander übergehen, wenn $\hat{u}_j^{(1)}(s_j) \neq \hat{u}_j^{(2)}(s_j)$; hierdurch wird dann $\hat{L}_j = f(\hat{L}_j, \Delta)$.

c) Endgültige Entscheidung:

Ein Zustand $s_{k\,opt}$ mit minimalem $\Gamma(s_k)$ ist zu finden.

Die harte Entscheidung ist dann $\hat{u}_{k-\delta}(s_{k\,opt}) \in \{\pm 1\}$.

Die Soft Decision ist dann $\hat{u}_{k-\delta}(s_{k\,opt}) \cdot \hat{L}_{k-\delta}(s_{k\,opt}) \in \mathbb{R}$. (*)

d) Der Wert k ist auf den Wert $k+1 \big|_{\mathrm{mod}\ \delta+1}$ zu setzen und dann zu wiederholen.

Bemerkungen:

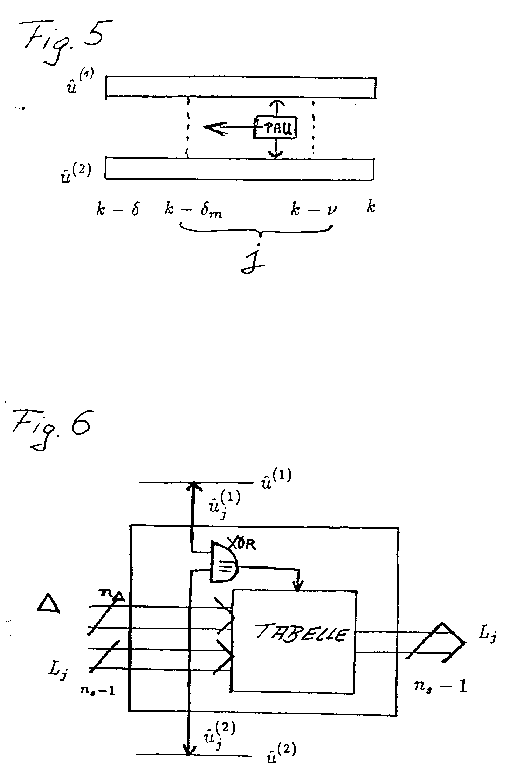

Nur durch die mit (*) gekennzeichneten Schritte ist der klassische Viterbi-Algorithmus gemäß der Erfindung ergänzt. Zur besseren Erläuterung des Algorithmus werden die Hard- und Soft-Decision-Werte in zwei verschiedenen Feldern der Länge $\delta+1$ gespeichert. (Siehe Fig.4) Hierbei können die Hard-Decision-Werte als die Vorzeichen der Soft-Decision-Werte betrachtet werden.

Die Speicherung wird Modulo $\delta+1$ durchgeführt, um Nachrichten beliebiger Länge zuzulassen. Natürlich kann die endgültige Entscheidung zuerst getroffen werden und danach kann die freie Position durch die aktuellen Werte überschrieben werden. Dies bedeutet eine Modulo $\delta$-Operation und führt zu einer Reduzierung hinsichtlich der Speichergröße. Eine Initialisierung mit $+\infty$ bedeutet den höchstmöglichen Wert. Additive Metriken haben die Eigenschaft, daß eine von y unabhängige Multiplikation oder Addition die Entscheidung nicht ändert. Hierdurch wird es möglich,

$$\Gamma(s_{k-1}, s_k) = \Gamma(s_k) - 2 \frac{E_s}{N_0} \sum_{n=1}^{N} y_{kn} \cdot x_{kn}^{(m)}. \qquad\qquad (12)$$

aktualisieren.

Da $x_{kn} \in \{\pm 1\}$ gilt, kann eine Realwert-Multiplikation vermieden werden. Darüber hinaus ist es möglich, den Faktor $2\,E_s/N_0$ fallenzulassen und diesen Term in der Berechnung von $\Delta$ entweder durch Multiplikation oder durch Erweitern der aktuellen Tabelle auf die Form $f(L_k, \Delta, E_s/N_0)$ auszukommen. Ein Langzeit-Signal-Rauschleistungsverhältnis muß mit Hilfe bekannter Verfahren berechnet werden. Eine schlechte Schätzung wirkt sich jedoch nur geringfügig auf die Leistung aus und beeinflußt nicht das Vorzeichen der Entscheidungen.

Anstelle der optimalen Prozedur, wie sie oben beschrieben wurde, bieten sich zwei modifizierte, aufwandsgünstige Lösungen an:

1) Es wird der Zustand mit der günstigsten Metrik gesucht, und nur der ML-Pfad wird aufgefrischt. Dadurch erfolgt eine Reduktion der "soft"-Auffrischung um den Faktor 2 .

2) Die Suche erfolgt generell nur im Bereich von $j = k - \nu$ bis $j = k - \delta'$ mit $\delta' < \delta_m \leq \delta$.

Zu 2) ist zu betonen, daß die Informationsbit im Intervall von $k - (\nu + 1)$ nach $k - \nu$ immer abweichen. Es bietet sich deshalb an, $\delta' = \nu + 1$ zu setzen. Dieser Spezialfall ist deshalb so interessant, weil eine "Suche" entfallen kann, und weil der sogenannte "Update"-Wert durch eine einmalige Operation ersetzt wird. Es dann nämlich jeweils $\Delta = M_1 - M_2$ direkt als Zuverlässigkeitswert an die zugehörige Speicherposition des für jeden Zustand überlebenden Pfades beschrieben werden. Eine Initialisierung ist demnach ebenfalls überflüssig. Schließlich ist noch festzustellen, daß die klassische Viterbi-Recursion mit Hilfe der Standardlösungen normiert werden kann. Die neuesten Soft-Deciding-Werte erfordern, abgesehen vom Wert $\alpha$, keine weiteren Normierung.

Technische Realisierung

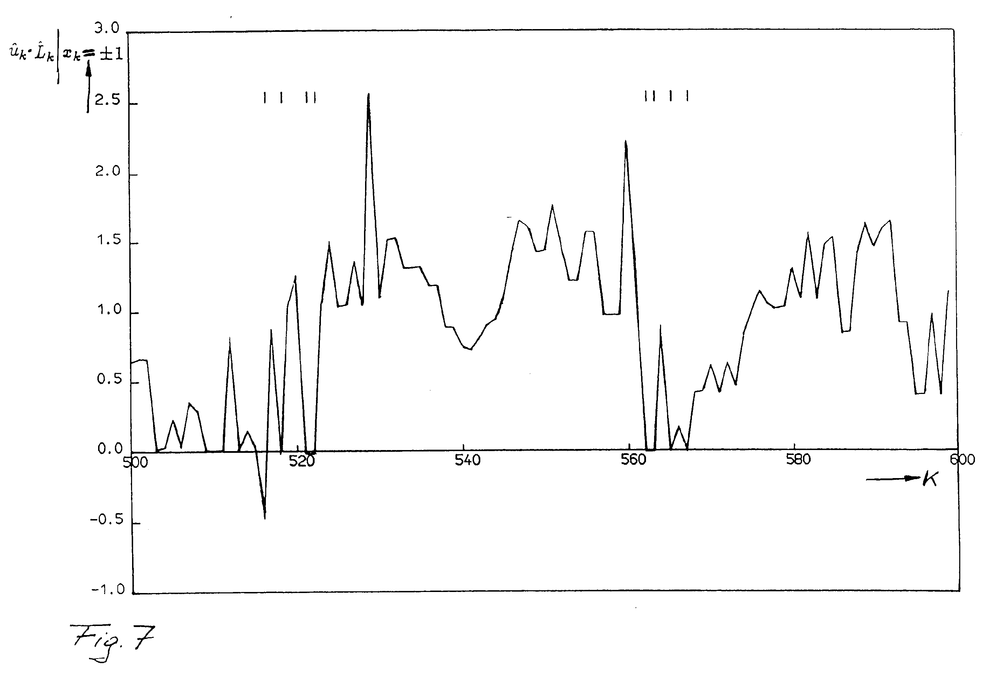

Wie in Fig.4 schematisch angedeutet ist, besteht bei einer $n_s$ Bit-Soft-Decision und einer Festpunkt-Arithmetik jeder Überlebenspfad der Länge $\delta$ aus $n_s \cdot \delta$ Bits. Das erste der $n_s$ Bits ist das Vorzeichenbit oder das Hard-Decision-Bit. Die Wahrscheinlichkeitswerte sind dann $L_k \in \{0, 1, ..., 2^{ns-1}-1\}$. $L_k = 0$ zeigt den unzuverlässigsten Wert an und $L_k = 2^{ns-1}-1$ gibt den zuverlässigsten Wert an. Wenn die Metrik-Differenz $\Delta$ gegeben ist, welche mit $n_\Delta$ Bits quantisiert worden ist, ist der aktualisierte Wahrscheinlichkeitswert in der in Fig.6 dargestellten Tabelle gegeben. Die Tabelle wird nur einmal mit Hilfe der Gl.(10) berechnet und dann in einem ROM-Speicher gespeichert. Folglich ist der zusätzliche Aufwand des Soft-Deciding-Viterbi-(SDV-)Algorithmus bezüglich des Viterbi-Algorithmus:

Speicherung:
- $2^v \cdot \delta \cdot n_s$ Bits anstelle von $2^v \cdot \delta$ Bits
- Verweistabelle mit $2^{n_\Delta + n_s - 1}$ Vektoren mit jeweils $n_s - 1$ Bits.

Berechnungs-Aufwand:
- Maximal $2^v \cdot (\delta - v)$ Bit-Vergleiche
- $2^v \cdot e$ Tabellenverweise, um $L_k$ zu aktualisieren.
- Langfristiger Kanalschätzwert zur Berechnung des Signal-Rauschleistungs-Verhältnisses.

Der Datentransfer wird im einzelnen nachstehend noch erläutert.

Die Größe e ist eine Zufallszahl und hängt von dem Kanalrauschen und der Code-Struktur ab. Für ein hohes Signal-Rauschleistungs-Verhältnis gilt:

$$e = \frac{\bar{c}_{dfree}}{a_{dfree}}, \qquad (13)$$

wobei $c_{dfree}$ die Gesamtanzahl an Bitfehlern in allen $a_{dfree}$-Pfaden freiem Abstand $d_{free}$ normiert auf ein Informationsbit, ist. Für ein niedriges Signal-Rauschleistungs-Verhältnis ist die Größe e nach oben begrenzt durch

$$\frac{1}{2}(\delta - v). \qquad (14)$$

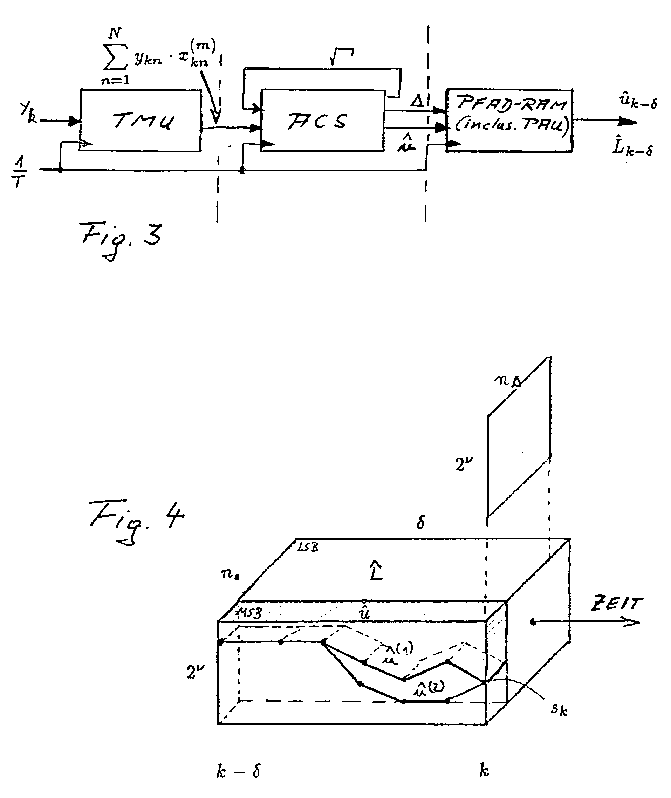

Der Soft-Deciding-Viterbi-(SDV-)Algorithmus kann in einer "Pipeline"-Struktur durchgeführt werden (wobei mit einer Symbolrate 1/T getaktet wird. (Siehe Fig. 3)) Folglich ist eine sehr schnelle Durchführung möglich. Die hierfür erforderlichen Einheiten sind eine Metrik-Inkrement-Einheit (Transition Metric-Unit (TMU)), eine Addier-Vergleich-Auswähl-(ACS-)Einheit und ein Pfad-RAM (einschließlich einer Pfad-Auffrisch-Einheit (PAU)). Hierbei gibt es keine Wechselwirkung zwischen der ACS-Einheit und dem Pfadspeicher-RAM.

Für jedes empfangene Symbol $y_k$ berechnet die TMU-Einheit die Metrik-Inkremente für alle möglichen Übergänge. Diese Einheit ist dieselbe wie die entsprechende Einheit in einem herkömmlichen Viterbi-Algorithmus. Es ist nur eine andere TMU-Einheit hinzuzufügen, wenn der (Soft-Deciding-)Viterbi-Algorithmus als Demodulator, Decoder oder Entzerrer arbeitet.

Die TMU-Einheit liefert die Metrik-Inkremente an die ACS-Einheit, welche die Metrik-Aktualisierung durchführt (siehe Gl.(12)). Die ACS-Einheit bleibt auch unverändert im Vergleich mit dem herkömmlichen Viterbi-Algorithmus. In Viterbi-Algorithmen ist die ACS-Einheit der Engpaß. Diese Einheit begrenzt die Geschwindigkeit, da jede Rekursion beendet sein muß, bevor die nächste starten kann. Ein weiteres Pipelining dieser Einheit ist unmöglich. Daher wird bei zeitkritischen Anwendungen diese Einheit für jeden Zustand in paralleler Form ausgeführt. Die einzige Modifikation der ACS-Einheit für den Soft-Deciding-Viterbi-Algorithmus gehört zu der Berechnung von $\Delta$, welche lediglich eine n-Bit-Subtraktion ist, und der größere Datentransfer zwischen der ACS-Einheit und der Pfadspeicher-Einheit von $(1 + n_\Delta)$ Bits statt einem Bit.

Schließlich werden die Daten in dem Pfad-RAM gespeichert; nur diese Speicher-Einrichtung muß daher geändert werden. Normalerweise wird die Information in jedem Zustand decodiert und das bzw. die Informations-Bit(s) wird bzw. werden zusammen mit der Folge gespeichert, die zu dem vorherigen Zustand geführt hat. Nun werden jedoch nicht nur die harten Informationsbits, sondern auch ein Vektor von $n_s$ Bits gespeichert, welcher auch die Zuverlässigkeitsinformation enthält.

Ein Blockdiagramm eines modifizierten Pfad-RAM ist in Fig.4 dargestellt. Er ist als eine $2^v \cdot \delta \cdot n_s$ - Matrix organisiert, wobei $2^v \cdot \delta$ Bits zu den Hard-Decisions gehören, während der Rest die Zuverlässigkeitsinformation ist.

Die Soft-Deciding-Aktualisierung ist in Fig.5 dargestellt. Es werden zwei Pfade angenommen, welche zum Zeitpunkt k divergieren und zum Zeitpunkt k - $\delta_m$ wieder zusammenkommen. (Siehe Fig.2 und 4). Eine sogenannte Pfad-Auffrisch-Einheit (PAU) wird verwendet, welche über die gespeicherten Informationsbits "gleitet". Der Bereich, wo die Informationsbits $u^{(1)}$ und $u^{(2)}$ verschieden sein können, ist j = k - $\delta_m$ bis j = k - $\nu$ . In all den Fällen, in welchen die Bits beim Tabellenlesen verschieden sind, wird über Gl.(10) deren Aktualisierung ermöglicht. Das Freigabesignal wird einfach durch ein XOR-Gate erzeugt. (Siehe Fig.6).

Diese serielle Realisierung begrenzt den Schaltungsaufwand, verlangsamt aber die Geschwindigkeit. Jedoch kann die Pfad-Auffrisch-Einheit (PAU) auch in paralleler Form, z.B. in ($\delta$ - $\nu$) gesonderten Einheiten pro Zustand realisiert werden. Dann hat jede Einheit nur ein Bit-Paar zu vergleichen und (höchstens) eine Tabellen-Auffrischung für jedes Symbol durchzuführen. Wenn dies mit der Einheit ASC verglichen wird, in welcher Operationen mit reellen Zahlen durchzuführen sind, dann bleibt die Einheit ASC der Engpaß. Der Soft-Deciding-Viterbi-Algorithmus begrenzt nicht die Geschwindigkeit.

Die endgültige Entscheidung unterscheidet sich nicht von dem herkömmlichen Register-Austauschverfahren; lediglich der Datentransfer ist um einen Faktor $n_s$ größer.

Anwendungsmöglichkeiten der Erfindung

Der erfindungsgemäße Viterbi-Algorithmus mit Analog-Entscheidungen (SDVA) arbeitet besser als ein herkömmlicher Viterbi-Decoder, -Demodulator oder -Entzerrer, wenn eine Verkettung gegeben ist. Dies kann einschließen Modulationen mit Gedächtnis, z.B. eine Trellis-codierte Modulation (TCM), oder Modulationsverfahren mit konstanter Einhüllender, wie CPM (Continuous Phase Modulation) oder TFM (Tamed FM), Kanäle mit Speicher, z.B. Filterkanäle mit Nachbarsymbol-Interferenz (ISI), frequenz-selektive Kanäle oder auch Speichermedien, wie magnetische Aufzeichnungen; ein Codieren mit Speicher, z.B. Faltungscodes, und alle möglichen Kombinationen daraus.

Im folgenden werden einige Anwendungen von praktischem Interesse beschrieben. Von der Anmelderin wurde der Nutzeffekt des erfindungsgemäßen Viterbi-Algorithmus mit Analogwert-Entscheidungen (SDVA) untersucht und die Ergebnisse wurden mit dem SD-MAP-Algorithmus verglichen, welcher der optimale symbolweise Empfänger ist. Auch wurden umfassende Computer-Simulationen durchgeführt. Die Ergebnisse zeigen, daß die Verschlechterung des SDV-Algorithmus im Vergleich zum SD-MAP-Algorithmus in der Größenordnung von 0,2 dB liegt. Jedoch ist der Gewinn verglichen mit den Hard-Decisions 2 dB bis 6 dB.

Ein verkettetes Codieren mit inneren und äußeren Faltungscodes ist ebenfalls sehr vielversprechend. Bei dem inneren Code werden die soft-quantisierten empfangenen Abtastwerte verwendet, die im Falle von Kanälen mit Gedächtnis möglicherweise durch die Verwendung von Kanalzustandsinformation verbessert werden können. Mit den vorstehend erwähnten Empfängern kann auch der äußere Decoder eine Soft-Decision-Maximum-Likelihood-Decodierung durchführen.

Beispielsweise wurde als innerer Code der Code mit R = 1/2 und $\nu$ = 3 verwendet, und als äußerer Code der punktierte (gelochte) Code mit R = 2/3 und $\nu$ = 3 verwendet. (Siehe Tabelle 1). Beide Codes wurden durch Spreizung getrennt. Die Gesamtcoderate ist R = $R_i$ . $R_o$ = 1/3.

Da alle Codes von demselben Muttercode abgeleitet werden, sind die Netzdiagramme dieselben und vorteilhafterweise werden beide Codes entsprechend verarbeitet, die denselben Viterbi-Algorithmus nutzen, bei welchem der neue soft-verbesserte Empfänger für den inneren Code und der herkömmliche Viterbi-Algorithmus für den äußeren Code verwendet wird. Auch ist bereits eine Struktur geschaffen, bei welcher in effizienter Weise ebenfalls das Spreizen gemeinsam genutzt wird.

Im Ergebnis sind dann die Bitfehler-Kurven steiler und folglich vielversprechender. Dies gilt bei Verknüpfen von zwei Codes im Vergleich zu einem einzelnen Faltungscode einer Rate von 1/3 und derselben Empfänger-Komplexität. Der Gewinn ist 0,7 dB bei $P_b$ = $10^{-5}$. Eine Verknüpfung ohne die Verwendung von Soft-Decisions ist aussichtslos.

Hinsichtlich einer optimalen Aufteilung zwischen dem inneren und äußeren Code wurden mehrere niederratige, raten-kompatible, gelochte Codes (RCPC-Codes) als innere Codes und ausgewählte hochratige gelochte Codes so verwendet, daß die Gesamtrate R = $R_i$. $R_o$ = 1/3 erhalten blieb ($R_i \leq R_o \leq$ 1). Die wichtigsten Parameter der ausgewählten Codes sind in der am Ende der Beschreibung angegebenen Tabelle 2 aufgelistet. Simulationen haben gezeigt, daß für niedrige Signal-Rauschleistungs-Verhältnisse der äußere Code mit der höchsten Rate erwartungsgemäß am besten arbeitet. Jedoch ist in dem interessierenden SNR-Bereich die Aufteilung von $R_i$ = 1/2 und $R_o$ = 2/3 die beste.

Auch bei Faltungscodes besteht in einer optimalen und eleganten Weise die Möglichkeit einer Soft-Decision-Decodierung. Auch gibt es einfache Blockcodes, die mit "soft decisions" decodiert werden können. Solche Codes sind z.B. Parity Check Codes oder Golay Codes. Solche Codes können dem SDV-Algorithmus nachgeschaltet werden und führen als Stufendecodierung zu erheblichen Verbesserungen.

Eine mögliche Anwendung dieser Kombination von Faltungscodes ist die Kanalcodierung in dem GSM-System. Hierbei wird die Codierung (bei "full rate speed") üblicherweise auf folgende Weise durchgeführt: Ein Block von 260 netto Sprachbits wird in drei Empfindlichkeits-oder Sensibilitätsklassen zusammengefaßt. Die 50 Bits der empfindlichsten Klasse (Klasse 1a) werden um 3 Paritätsbits vergrößert, um unkorrigierbare Fehler festzustellen. Bei einem Fehler wird gewöhnlich der gesamte Block ignoriert und es findet eine Interpolation statt. Es soll nun ein "partieller Soft-Deciding-Viterbi-Algorithmus" mit Parity-Check angenommen werden, welcher Soft-Decisions nur bei Bits der Klasse 1a und Hard-Decisions für die restlichen Bits der Klasse 1b liefert. Dann kann ein Soft-Decision-Parity Check durchgeführt werden, der gegebenenfalls weitere Fehler korrigiert.

Alternativ kann, wenn Fehler durch den Parity Check festgestellt werden, eine Überlagerung (Maximum-Ratio Combining) mit dem "soft"-Wert $m^{x_k(-1)}$ des vorherigen Blocks durchgeführt werden:

$$x_k := (x_k + x_k^{(-1)})/2$$

Dies kann gegebenenfalls auch durch Kanalzustandsinformationen $q_k$ verbessert werden:

$$x_k = (q_k x_k + q_k^{(-1)} x_k^{(-1)})/2$$

Dadurch wird eine "weiche" Kombination statt einer "harten" Interpolation erreicht.

Codierte Modulation ist in den letzten Jahren auf großes Interesse gestoßen. Der Grund hierfür ist die Bandbreiten-Effizienz. Im Unterschied hierzu führen Faltungscodes zu einer Bandbreitendehnung, welche proportional der Code-Rate ist, wenn die Anzahl der Elemente des Symbolraumes unverändert bleibt.

Hierzu wurde die Leistungsfähigkeit des Ungerboeck-Codes mit 4 Zuständen und der Rate von 2/3 untersucht. Das Signal sei durch weißes Gaußsches Rauschen gestört, und wird mittels des Soft-Deciding-Viterbi-Algorithmus verarbeitet. Die modifizierte Gaußsche Wahrscheinlichkeitsmetrik liest sich dann (im Vergleich zu Gl.(4)) folgendermaßen:

$$M_m = -\frac{E_s}{N_0} \sum_k |y_k - x_k^{(m)}|^2, \qquad\qquad (15)$$

wobei $x_k^{(m)}$ das komplexe Symbol des m-ten Pfades ist, welcher dem Netzdiagramm entspricht, und $y_k$ der empfangene komplexe Wert zur selben Zeit k ist, wobei $x_k^{(m)}$ und $y_k$ in komplexer Schreibweise angeführt sind. Im Ergebnis ist dann das Signal-Rauschleistungs-Verhältnis (SNR) des Soft-Deciding-Viterbi-Algorithmus viel besser als am Eingang (üblicherweise um mehr als 3 dB). Mit diesem verbesserten Signal-Rauschleistungs-Verhältnis (SNR) arbeitet dann ein Decoder in der nächsten Stufe viel besser.

Das Entzerren ist eine Herausforderung bei schnellen digitalen Übertragungen über zeit-dispersive Kanäle, z.B. Mobilfunkkanäle. Hierbei führt der Viterbi-Entzerrer die gewünschte maximal wahrscheinliche Folgenbewertung durch. Jedoch ist in codierten Systemen die Schwierigkeit offensichtlich, daß der Viterbi-Entzerrer Hard-Decisions an den äußeren Decoder liefert.

Es wurde daher der SDV-Algorithmus und der SD-MAP-Algorithmus bei frequenzselektiven Fading-Kanälen untersucht. Für den Kanal wurde eine mit Abgriffen versehene Verzögerungsleitung mit (L + 1) unabhängigen Verstärkungsfaktoren angenommen. Dieser Kanal, der eine Idealisierung des mobilen Mehrwegkanals darstellt, kann als der innere Code angesehen werden. Die modifizierte Gaußsche Wahrscheinlichkeitsmetrik liest sich dann (im Vergleich zu Gl.(4)) folgendermaßen:

$$M_m = -\frac{\overline{E}_s}{N_0} \sum_k |y_k - \sum_{l=0}^{L} f_k^{(l)} x_{k-l}^{(m)}|^2, \qquad\qquad (16)$$

wobei $x_k^{(m)}$ das Symbol für den m-ten Weg ist, welcher dem Netzdiagramm entspricht, $f_k^{(l)}$ der $\ell$-te Verstärkungsfaktor ist (wobei $0 \leq \ell \leq L$ gilt, wenn $y_k$ der empfangene Wert zum selben Zeitpunkt k ist, wobei $x_k^{(m)}$, $y_k$ und $f_k^{(l)}$ in komplexer Schreibweise erscheinen. Der Wert $\overline{E}_S/N_0$ ist der mittlere Signal-Rauschleistungs-Verhältniswert. Es zeigt, daß die Veränderliche am Ausgang des SDV-Algorithmus und des SDMAP-Algorithmus zumindest in dem interessierenden Signal-Rauschleistungs-Verhältnis-Bereich annähernd eie Gaußsche Verteilung aufweist. Dies zeigt an, daß der frequenz-selektive Fading -Kanal in einen AWGN-Kanal transformiert wird, wenn die Spreizung groß genug ist. Als äußerer Code wurde ein Faltungscode der Rate 1/2 mit einem Gedächt-

nis $\nu = 3$ gewählt (siehe Tabelle 1). Der Gewinn bei dem SDV-Algorithmus und bei dem SDMAP-Algorithmus liegt jeweils bei $P_b = 10^{-3}$ in der Größenordnung von 4 dB im Vergleich zu den Hard-Decisions. Ähnliche Ergebnisse wurden für Trellis-Codes als äußere Codes hergeleitet. Wie erwartet, ist der Gewinn infolge Soft-Decisions umso größer, je schlechter der Kanal ist. Deswegen ist ein erfindungsgemäßer Soft-Deciding-Viterbi-Empfänger vor allem bei Fading-Kanälen in besonders vorteilhafter Weise zu verwenden.

## Tabelle 1
## Code-Parameter für Faltungscodes

| Code | $i$ | $d_i$ | $\tilde{c}_{d_i}$ |
|---|---|---|---|
| $R = 1/3$ | 0 | 10 | 6 |
| | 1 | 11 | 0 |
| | 2 | 12 | 6 |
| | 3 | 13 | 0 |
| | 4 | 14 | 58 |
| $R = 1/2$ | 0 | 6 | 2 |
| | 1 | 7 | 7 |
| | 2 | 8 | 18 |
| | 3 | 9 | 49 |
| | 4 | 10 | 130 |
| $R = 2/3$ | 0 | 4 | 5 |
| | 1 | 5 | 21.5 |
| | 2 | 6 | 100 |
| | 3 | 7 | 413 |
| | 4 | 8 | 1657 |

| | |
|---|---|
| $R = 1/3$, $R = 1/2$: | Muttercodes |
| $R = 2/3$: | punktierter Code |
| Gedächtnis: | $\nu = 3$ |
| Generatorpolynome: | 15, 17, 13 (in oktaler Schreibweise) |
| $d_i$: | Distanzspektrum |
| $c_{di}$: | Informations-Gewichtsspektrum (wobei $c_{di}$ auf jedes Informations-bit normiert ist). |

Tabelle 2

Code-Parameter für punktierte Faltungscodes

| Innerer Code | | | Äußerer Code | | |
|---|---|---|---|---|---|
| $R$ | $d_{free}$ | $c_{d_{free}}$ | $R$ | $d_{free}$ | $c_{d_{free}}$ |
| 1/2 | 6 | 2 | 2/3 | 4 | 5 |
| 4/9 | 6 | 0.5 | 3/4 | 4 | 41.3 |
| 2/5 | 7 | 1 | 5/6 | 3 | 12.6 |
| 8/21 | 7 | 0.25 | 7/8 | 2 | 0.6 |

Innere Codes:     punktierte Codes

Äußere Codes:    punktierte Codes

Gedächtnis:     $\nu = 3$

Generator-Polynome:  15, 17, 13 (in oktaler Schreibweise)

$d_{free}$:       Distanzspektrum

$c_{d_{free}}$:      normierte Anzahl von Bitfehlern des

         Minimum-Distanzpfades

         (pro Informationsbit)

**Patentansprüche**

1. Verfahren zur Verallgemeinerung des Viterbi-Algorithmus, bei welchem in einer Metrik-Inkrement-Einheit (TMU) die Übergangskosten gebildet werden und in der nachgeschalteten Addier-Vergleich-Auswähl-(ACS-)Einheit ein Addieren, ein Vergleichen sowie ein Auswählen vorgenommen werden, **dadurch gekennzeichnet, daß**
für jeden Zustand die Differenzkosten von zwei eintreffenden Pfaden berechnet werden, wobei eine Zuverlässigkeitsinformation am Anfang jedes Pfades auf den höchsten Wert festgelegt wird,
dann der Zuverlässigkeitswert des Pfades mit den kleinsten Kosten an den Stellen aufgefrischt wird, wo die Informationsstellen von dem konkurrierenden Pfad abweichen, wobei das Auffrischen gemäß einer Tabelle vorgenommen wird und wobei der vorherige Wert der Zuverlässigkeitsinformation und die Differenzkosten (Δ) als Eingangsgröße in der Tabelle angelegt werden,
hierauf der neue Wert aus der Tabelle entnommen wird und zusammen mit harten Entscheidungen als Pfadgedächtnis abgespeichert wird, wobei das Abspeichern in Form von Fest- oder Gleitpunkt-Werten erfolgt, und
schließlich die Analogwertentscheidung aus der Stelle herausgelesen wird, die sich nach einer Entscheidungsverzögerung (δ) für den Pfad mit den kleinsten Kosten ergibt, wo bei das Vorzeichen der Analogwert-Entscheidungen die harten Entscheidungen des bekannten Viterbi-Algorithmus sind.

2. Verfahren zum Modifizieren des Viterbi-Algorithmus nach Anspruch 1, dadurch **gekennzeichnet, daß** zum Auffrischen der Zuverlässigkeitsinformation das Minimum aus der alten Zuverlässigkeitsinformation und - durch Einführen eines Faktors ($\alpha$) - den normierten Pfad-Differenzkosten ($\Delta/\alpha$) gebildet wird und als Pfadgedächtnis abgespeichert wird.

3. Verfahren nach Anspruch 1 oder Anspruch 2, dadurch **gekennzeichnet, daß** zum Pfadauffrischen eine Pfad-Auffrischeinheit (PAU) in einem gewissen Bereich (k- $\nu$ bis k-$\delta_p$ mit $\nu \leq \delta_p \leq \delta_m$) die Informationsbits der beiden konkurrierenden Pfade auf Gleichheit überprüft und bei einer Ungleichheit den Auffrischvorgang aktiviert, wobei mit k ein Zeitindex, mit $\nu$ ein Codegedächtnis und mit δ eine Verzögerung bzw. Eindringtiefe bezeichnet sind.

4. Einrichtung zum Durchführen der Verfahren nach den Ansprüchen 1 bis 3, mit einer Metrik-Inkrement-Einheit (TMU), in welcher die Kosten gebildet werden, und mit einer Addier-Vergleich-und Auswähl-(ACS-)Einheit, in welcher ein Addieren, ein Vergleichen sowie ein Auswählen vorgenommen werden, dadurch **gekennzeichnet,** daß der Addier-Vergleich-Auswähl-(ACS-)Einheit ein Pfad-RAM sowie eine Pfad-Auffrischeinheit (PAU) nachgeschaltet sind, um zum Pfadauffrischen in einem bestimmten Bereich (k - $\nu$ bis k - $\delta_m$) die Informationsbits der beiden konkurrierenden Pfade auf Gleichheit zu überprüfen, und um bei Ungleichheit den Auffrischvorgang in dem Pfad-RAM zu aktivieren.

5. Einrichtung nach Anspruch 4, **gekennzeichnet** durch eine Einrichtung zum Normieren des Auffrischens der Zuverlässigkeitsinformation durch Einführen eines Faktors ($\alpha$), um dadurch einer Festkomma-Darstellung zu genügen, und um einen Überlauf zu vermeiden.

6. Einrichtung nach einem der Ansprüche 4 oder 5, dadurch **gekennzeichnet,** daß für jeden von S-Zuständen jeweils eine Pfad-Auffrischeinheit (PAU) in der Weise vorgesehen ist, daß durch diese Parallelanordnung bezüglich des Vorsehens nur einer einzigen Pfad-Auffrischeinheit (PAU) Zeitgewinne in der Größe eines Faktors S erzielt werden.

7. Einrichtung nach einem der Ansprüche 4 bis 6, dadurch **gekennzeichnet,** daß für jedes Zeitintervall (k - $\nu$ bis k - $\delta_p$) eine gesonderte Pfad-Auffrischeinheit (PAU) in der Weise vorgesehen ist, daß durch eine derartige Parallelanordnung Zeitgewinne in der Größe eines Faktors ($\nu$ - $\delta_p$) erzielbar sind.

## Claims

1. A method for generalizing the conventional Viterbi algorithm, in which the transition costs are formed in a metric increment unit (TMU) and adding, comparing and selection are performed in a succeeding add-compare-select (ACS) unit, **characterized** in that the difference costs from two arriving paths are calculated for each individual state, the reliability information at the beginning of each path being set to the highest value, then the reliability value of the path with the least costs is updated at the points where the information points differ from the competing path, updating being performed in accordance with a table, and where the prior value of the reliability information and the difference costs ($\Delta$) is being inserted into the table as input values, then this new value is being taken from the table and stored, together with hard decisions, as path memory, storage being in the form of fixed or sliding point values, and finally an analog value decision is being read out from the point which, after a defined decision delay ($\delta$), is the result for the path with the lowest costs, where the hard decisions of the conventional Viterbi algorithm are the signs of the analog value decision.

2. A method for modifying the Viterbi algorithm in accordance with claim 1, **characterized** in that the minimum from the old reliability information and - by the introduction of a factor ($\alpha$) - normalized path differences costs ($\Delta/\alpha$) is formed for updating the reliability information, and this new value is then stored as path memory.

3. A method in accordance with claim 1 or claim 2, **characterized** in that for path updating a path updating unit (PAU) checks in a defined area (k - $\nu$ to k - $\delta_p$ with $\nu \leq \delta_p \leq \delta_m$) the information bits of the two competing paths for concurrence and, if a non-concurrence is noted, activates the updating procedure and where k identifies a time index, $\nu$ a code memory and $\delta$ a delay or penetration depth.

4. A device for executing the method in accordance with claims 1 to 3, with a metric increment unit (TMU) in which the costs are formed and an add-compare-select (ACS) unit, in which addition, comparison and selection are performed, **characterized** in that a path-RAM as well as a path updating unit (PAU) are placed after the add-compare-select (ACS) unit, so as to check for concurrence the information bits of the two competing paths for path updating in an exactly defined area (k - $\nu$ to k - $\delta_m$), and, in case of non-concurrence, to activate the updating process in the path RAM.

5. A device in accordance with claim 4, **characterized** by a device for standardizing the updating of the reliability information by introducing a factor ($\alpha$) to satisfy a fixed point representation and to avoid overflow.

6. Device in accordance with one of claims 4 or 5, **characterized** in that for each S-state a path updating unit (PAU) is provided in such a way that, on the basis of this parallel arrangement in view of the provision of only a single path updating unit (PAU), a gain in time of the value of the factor S is achieved.

7. Device in accordance with one of claims 4 to 6, **characterized** in that for each time interval (k - $\nu$ to k - $\delta_p$) a seperate path updating unit (PAU) is provided in such a way, that it is possible, because of this parallel design, to attain gains of the value of a factor ($\nu$ - $\delta_p$).

## Revendications

1. Procédé de généralisation de l'algorithme de Viterbi dans lequel les coûts de transition sont formés, dans une unité à incréments métriques (TMU) alors qu'est effectué dans l'unité d'addition-comparaison-sélection (ACS) montée à la suite une addition, une comparaison ainsi qu'une sélection, caractérisé en ce que, pour chaque état, les coûts différentiels de deux chemins arrivants sont calculés et l'information de fiabilité est fixée au début de chaque chemin sur la valeur la plus haute,
la valeur de fiabilité du chemin est ensuite rafraîchie avec les coûts les plus faibles aux emplacements où les position d'information dévient du chemin concurrent, le rafraîchissement étant effectué au moyen d'un tableau, la valeur d'information de fiabilité précédente et les coûts différentiels ($\Delta$) étant utilisés en tant que grandeurs d'entrée dans le tableau,
la nouvelle valeur est ensuite prélevée du tableau et mise en mémoire en tant que mnémonique de chemin avec des décisions dures, la mise en mémoire ayant lieu sous forme de valeurs à virgule fixe ou flottante, et
finalement la décision en valeurs analogiques est lue à partir de l'emplacement que l'on obtient après un retard de décision ($\delta$) pour le chemin dont les coûts sont les plus faibles,
les décisions dures de l'algorithme de Viterbi connu constituant le signe des décisions en valeurs analogiques.

2. Procédé pour modifier l'algorithme de Viterbi selon la revendication 1, caractérisé en ce que, pour rafraîchir l'information de fiabilité, on forme le minimum à partir de l'information de fiabilité ancienne et - par introduction d'un facteur ($\alpha$) - les coûts différentiels de chemin normalisés ($\Delta/\alpha$) et on le met en mémoire en tant que mnémonique de chemin.

3. Procédé selon la revendication 1 ou la revendication 2, caractérisé en ce que, pour le rafraîchissement du chemin, une unité de rafraîchissement de chemin (PAU) contrôle dans une plage déterminée (de k - $\nu$ à k - $\delta_p$, avec $\nu \leq \delta_p \leq \delta_m$) les bits d'information des deux chemins concurrents en ce qui concerne leur égalité, et dans le cas d'une inégalité active le processus de rafraîchissement, un indice de temps étant désigné par k, une mnémonique de code par $\nu$ et un retard ou une profondeur de pénétration par $\delta$.

4. Dispositif pour la mise en oeuvre du procédé selon les revendications 1 à 3, comprenant une unité à incréments métriques (TMU) dans laquelle sont formés les coûts, et comprenant une unité d'addition-comparaison-sélection (ACS) dans laquelle sont effectuées une addition, une comparaison et une sélection, caractérisé en ce que l'unité d'addition-comparaison-sélection (ACS) est montée à la suite d'une mémoire RAM de chemin ainsi qu'une unité de rafraîchissement de chemin (PAU), pour contrôler les bits d'information des deux chemins coucurrents en ce qui concerne leur égalité et effectuer un rafraîchissement de chemin dans une zone déterminée (de k - $\nu$ à k - $\delta_m$), et activer le processus de rafraîchissement dans la RAM de chemin en cas d'inégalité.

5. Dispositif selon la revendication 4, caractérisé par un dispositif de normalisation de rafraîchissement de l'information de fiabilité par introduction d'un facteur ($\alpha$), pour que soit suffisante une représentation à virgule fixe et pour éviter un dépassement.

6. Dispositif selon la revendication 4 ou 5, caractérisé en ce que pour chacun de S états est prévue respectivement une unité de rafraîchissement de chemin (PAU), de manière que grâce à cet agencement en parallèle en ne prévoyant qu'une unique unité de rafraîchissement de chemin (PAU) on obtienne des gains de temps de l'ordre de grandeur d'un facteur S.

7. Dispositif selon l'une quelconque des revendications 4 à 6, caractérisé en ce que pour chaque intervalle de temps (de k - $\nu$ à k - $\delta_p$) on prévoit une unité de rafraîchissement de chemin (PAU) particulière de manière à obtenir par un agencement en parallèle de ce type des gains de temps de l'ordre de grandeur d'un facteur ($\nu$ - $\delta_p$).

Fig. 1

Fig. 2

$$\sum_{n=1}^{N} y_{kn} \cdot x_{kn}^{(m)}$$

Fig. 3

Fig. 4

Fig. 5

$\hat{u}^{(1)}$

ТАЦ

$\hat{u}^{(2)}$

$k-\delta \qquad k-\delta_m \qquad\qquad k-\nu \qquad\qquad k$

$j$

Fig. 6

$\hat{u}^{(1)}$

$\hat{u}_j^{(1)}$

XOR

$\Delta$

$n_\Delta$

TABELLE

$L_j$

$L_j$

$n_s-1$

$n_s-1$

$\hat{u}_j^{(2)}$

$\hat{u}^{(2)}$

Fig. 7

EP 0 391 354 B1